# EUROPÄISCHE PATENTSCHRIFT

(11) **EP 1 268 122 B1**
(45) Veröffentlichungstag und Bekanntmachung des Hinweises auf die Patenterteilung: **16.02.2005**
(21) Anmeldenummer: 01915299.0
(22) Anmeldetag: 27.02.2001
(51) Int. Cl.: B23P 19/04, B23Q 7/10

(54) **MAGAZIN, MONTAGEVORRICHTUNG FÜR MIKROBAUTEILE UND VERFAHREN ZUM MONTIEREN VON MIKROBAUTEILEN**
MAGAZINE, ASSEMBLY DEVICE FOR MICROCOMPONENTS AND METHOD FOR ASSEMBLING MICROCOMPONENTS
MAGASIN, DISPOSITIF DE MONTAGE POUR MICROCOMPOSANTS ET PROCEDE DE MONTAGE DE MICROCOMPOSANTS

(30) Priorität: 29.02.2000 DE 10009386
(43) Veröffentlichungstag der Anmeldung: 02.01.2003
(73) Patentinhaber: INSTITUT FÜR MIKROTECHNIK MAINZ GmbH, 55129 Mainz-Hechtsheim (DE)
(72) Erfinder: EHRFELD, Wolfgang, 55124 Mainz (DE); NIENHAUS, Matthias, 55128 Mainz (DE); BERG, Udo, 61348 Bad Homburg (DE); SCHMITZ, Felix, 55118 Mainz (DE); BEGEMANN, Marc, 32683 Barntrup (DE); ANSEL, Yannick, 55129 Mainz (DE)
(74) Vertreter: Fuchs Mehler Weiss & Fritzsche
(86) Internationale Anmeldenummer: PCT/EP2001/002195
(87) Internationale Veröffentlichungsnummer: WO 2001/064388

(56) Entgegenhaltungen:
- EP-A- 0 044 519
- DE-A- 3 928 712
- DE-A- 19 709 136
- US-A- 4 693 370

## Beschreibung

Die Erfindung betrifft ein Magazin und eine Montagevorrichtung für in dem Magazin angeordnete Mikrobauteile. Die Erfindung bezieht sich auch auf ein Verfahren zum Montieren von in einem Magazin angeordneten Mikrobauteilen.

Mikrobauteile werden in einem Magazin beim Weiterverarbeiter angeliefert und müssen dort aus dem Magazin für die Montage entnommen werden. Bei einem Magazin, wie es beispielsweise in der DE 197 09 136 A1 beschrieben ist, sind die Mikrobauteile in das waferförmige Magazin integriert, so daß sie vor Beschädigungen beim Transport geschützt sind. Aus diesem Magazin müssen die Mikrobauteile mittels eines Stempels herausgedrückt werden.

Der gesamte Magazinwafer muß zu diesem Zweck zunächst so positioniert werden, daß sich das jeweilige aus dem Magazin zu entnehmende Bauteil exakt an dem Ort befindet, wo es in eine bereits vorhandene Struktur aus Mikrobauteilen eingebaut werden soll. Wenn beispielsweise ein Getriebe aus Mikrobauteilen zusammengesetzt werden soll, müssen die entsprechenden Zahnräder exakt über den sie aufnehmenden Wellen positioniert und anschließend aus dem Magazin herausgedrückt werden. Bisher werden die Magazinwafer entweder von Hand oder mittels eines automatisch arbeitenden Greifersystems erfaßt und positioniert.

Die Positionierung von Hand hängt entscheidend vom Können und der Konzentration der betreffenden Person ab, wobei Positionierhilfen, die im Magazin angeordnet sein können, nur bedingt oder gar nicht genutzt werden können.

Bei automatischen Greifersystemen werden beispielsweise Anschläge verwendet, an die der Magazinwafer mit seinem Rand angelegt wird. Durch Materialschwund des Magazin- und Mikrobauteilmaterials beim Herstellungsprozeß verändert sich jedoch die Position der Mikrobauteile. Daher wird das Abformwerkzeug bereits derart vergrößert ausgelegt, daß diese systematischen Schwindungen bei der Herstellung der Mikrobauteile berücksichtigt sind. Durch die Toleranzen dieser Schwindungen ergeben sich allerdings Positionstoleranzen der Mikrobauteile im Magazin, so daß selbst diejenigen Mikrobauteile, die benachbart zur Anlagekante angeordnet sind, sich derart verschoben haben können, daß sie nicht an der vorgesehenen Stelle im Magazin angeordnet sind. Um mehrere Bauteile aus dem Wafermagazin entnehmen zu können, muß das Magazin mittels einer Verschiebeeinrichtung hin- und hergeschoben werden, wobei sich Fehlpositionen von Mikrobauteilen aufaddieren können. Dies führt dazu, daß die Entnahmewerkzeuge, wie Stempel oder dergleichen, nicht an der Stelle angeordnet sind, wo sich auch das zu entnehmende Bauteil befindet bzw. die zu entnehmenden Bauteile befinden sich nicht exakt über der Stelle, wo die sie aufnehmende Struktur angeordnet ist. Dies führt entweder zu einer Beschädigung der Bauteile und des Magazins oder zu einer Beschädigung der größeren Mikrostrukturen, auf denen die Mikrobauteile plaziert werden sollen, oder auch zu einer Beschädigung der Entnahmewerkzeuge.

Es werden daher bereits optische Verfahren, d.h. Bildauswerteverfahren für die Positionierung der Mikrobauteile eingesetzt, wie dies beispielsweise in G. Reinhart et al., "Flexible Montage von Miniaturbauteilen", F+M 105 (1997) 1-2, S. 43-45, beschrieben wird. Hierbei besteht allerdings das Problem, daß kein ausreichender Kontrast zur Verfügung steht, weil sowohl das Magazin als auch die Mikrobauteile aus ähnlichen oder mit Herstellung einer Trennschicht sogar aus denselben Materialien hergestellt werden. Dies hat zur Folge, daß die Position der jeweiligen Mikrobauteile nicht exakt ermittelt werden kann. Die geforderte Genauigkeit von 5 µm und besser, die oftmals für eine exakte Positionierung der Mikrobauteile notwendig ist, kann daher nicht eingehalten werden.

Ein weiterer Nachteil besteht darin, daß Bilderkennungs- und auswerteeinrichtungen aufwendig sind und für die Positionierung relativ viel Zeit benötigt wird, weil das Wafermagazin bzw. die Werkzeuge in mehreren Raumrichtungen bewegt werden müssen.

Darüber hinaus kann sich das Wafermagazin beim Herausdrücken der Mikrobauteile durchbiegen, was ebenfalls zu Fehlpositionierungen führt.

Es ist daher Aufgabe der Erfindung, eine Montagevorrichtung zu schaffen, die auf den Einsatz von optischen Systemen verzichten kann und eine exakte Positionierung von in einem Magazin angeordneten Mikrobauteilen gewährleistet, wobei eventuell durch Schwund auftretende Positionsänderungen der Mikrobauteile den Montagevorgang nicht beeinträchtigen sollen. Es ist auch Aufgabe der Erfindung, ein Magazin zu schaffen, das auf einfache Weise eine Positionierung der Mikrobauteile ermöglicht sowie ein Verfahren zum Montieren von in dem Magazin angeordneten Mikrobauteilen bereitzustellen, bei dem eine Beschädigung der Mikrobauteile oder des Magazins oder der Entnahmewerkzeuge verhindert wird.

Diese Aufgabe wird mit einer Montagevorrichtung gelöst, die ein Oberwerkzeug und ein Unterwerkzeug aufweist, wobei diese Werkzeuge folgende Komponenten aufweisen:
- Mittel zur Grobjustierung des Magazins,
- mechanische Ausrichtmittel zur Feinjustierung, die in Justierstrukturen (42a-d,44a-d,45a-d) auf Magazinebene, und Clusterebene und/oder Mikrobauteilebene des Magazins (4) ein- oder angreifen und eine Ausrichtung der im Magazin befindlichen Mikrobauteile bewirken,
- Klemmmittel zum Fixieren des Magazins (4),
- mindestens einen Stempel (2a,b) zum Ausdrücken mindestens eines Mikrobauteils (3a,b) aus dem Magazin (4);
- eine Montageplattform (8) im Oberwerkzeug (101) oder im Unterwerkzeug (102) zur positionierten Aufnahme von Mikrobauteilen (3a,3b).

Das erfindungsgemäße Magazin besitzt zu diesem Zweck im Magazinmaterial Justierstrukturen zur Feinjustierung auf Magazin- und Cluster- und/oder Mikrobauteilebene zum Ein- oder Angreifen von mechanischen Ausrichtmitteln bei der Montage der Mikrobauteile, wobei die Justierstrukturen von der Magazinebene über die Clusterebene bis zur Mikrobauteilebene eine abnehmende Größe aufweisen. Die abnehmende Größe hat den Vorteil, dass auf Grund der deutlich höheren Anzahl der Strukturen der Platzbedarf ansonsten zu groß werden würde.

Als Justierstrukturen kommen Vorsprünge, Vertiefungen oder Durchbrüche im Magazinmaterial in Frage, mit denen die Ausrichtmittel zusammenwirken und eine Ausrichtung der im Magazin befindlichen Mikrobauteile bewirken.

Die Justierstrukturen sind vorzugsweise als kreisrunde, zylinder-, dreikant-, vierkant- oder polygonförmige Strukturen im Magazinmaterial ausgebildet. Die Justierstrukturen sind vorzugsweise Öffnungen mit einem Durchmesser von 100 µm bis 3 mm.

Im einfachsten Fall handelt es sich um kreisrunde Löcher oder Öffnungen im Magazinmaterial.

Die Justierstrukturen lassen sich im wesentlichen in drei genannten Gruppen einteilen. Es können Justierstrukturen auf Magazinebene, Clusterebene oder Mikrobauteilebene vorgesehen sein, was von den Toleranzen der zu montierenden Bauteile, deren Anordnung und vom Materialschwund des Magazin- und Mikrobauteilmaterials abhängt. Die größte Positioniergenauigkeit wird erreicht, wenn für die Positionierung des Magazins und der Mikrobauteile Justierstrukturen auf Bauteilebene benutzt werden. Die Justierstrukturen auf Bauteilebene sind benachbart zu dem jeweils zu entnehmenden Mikrobauteil angeordnet, so daß aufgrund der geringen Abstände zwischen dem zu montierenden Bauteil und der zugeordneten Justierstruktur ein Materialschwund vernachlässigbar ist.

Es werden für die Justierstrukturen auf Magazinebene Durchmeser im Bereich von 1 mm bis 3 mm, auf Clusterebene im Bereich von 500 µm bis 1 mm und auf Bauteilebene im Bereich von 100 µm bis 500 µm bevorzugt.

Die Justierstrukturen aller Ebenen sind vorzugsweise in regelmäßiger Anordnung vorgesehen. Da die Montagevorrichtung und die Vorrichtung zum Verschieben des Magazins computergesteuert sind, wird die Anordnung der Justierstrukturen vorzugsweise so gewählt, daß die Programmierung der Steuereinheiten möglichst vereinfacht wird.

Ferner weist die Montagevorrichtung Klemmmittel zum Fixieren des Magazins auf. Diese Klemmmittel sind derart angeordnet, daß sie im Bereich der zu montierenden Bauteile am Magazin angreifen, so daß beim Herausdrücken der Mikrobauteile aus dem Magazin ein Durchbiegen und somit eine Positionsverschiebung der Mikrobauteile nahezu verhindert wird.

Vorzugsweise sind die Klemmmittel in die Ausrichtmittel integriert. Dies bedeutet, daß beim Justieren auch gleichzeitig oder zeitversetzt das Magazin geklemmt bzw. eingespannt wird.

Ferner ist mindestens ein Stempel zum Ausdrücken mindestens eines Mikrobauteils vorgesehen. Der Stempel ist vorzugsweise zwischen den Ausricht- und/oder Klemmmitteln angeordnet. Es ist von Vorteil, wenn das Ober- und das Unterwerkzeug jeweils mindestens zwei Ausrichtstrukturen aufweisen, zwischen den das oder die Mikrobauteile angeordnet sind, die montiert werden sollen.

Schließlich weist die Montagevorrichtung noch eine Montageplattform auf, die im Unter- oder im Oberwerkzeug angeordnet sein kann. Auf dieser Montageplattform werden die Mikrobauteile oder auch andere größere Bauteilstrukturen abgelegt, die mit weiteren Mikrobauteilen bestückt werden. Die Montageplattform dient somit zur positionierten Aufnahme von Mikrobauteilen. Die Montageplattform und der Stempel sind vorzugsweise unabhängig voneinander senkrecht zur Oberfläche des Magazins bewegbar. Es besteht auch die Möglichkeit, eine gekoppelte Bewegung von Montageplattform und Stempel vorzusehen.

Vorzugsweise umfassen die mechanischen Ausrichtmittel eine obere und eine untere Ausrichtvorrichtung, die gegenüberliegend angeordnet sind, wobei mindestens eine Ausrichtvorrichtung in vertikaler Richtung beweglich angeordnet ist. Da das Magazin horizontal in der Montagevorrichtung plaziert wird, ist die vertikale Richtung mit der Richtung senkrecht zur Magazinebene identisch.

Mindestens eine der Ausrichtvorrichtungen weist mindestens einen Stift auf, der vorzugsweise ein Fangstift ist, der in die entsprechende Justierstruktur des Magazins eingreift. Der Durchmesser der Fangstifte liegt vorzugsweise im Bereich von 100 µm bis 3 mm und wird an die Justierstrukturen angepaßt.

Vorzugsweise weist der Stift eine Zentrierspitze auf, so daß das Magazin beim Eingreifen des Stiftes in die Justierstruktur in lateraler Richtung in die vorgesehene Position verschoben werden kann. Wenn das Magazin zunächst grob justiert worden ist, erfolgt durch das Eingreifen oder Angreifen der Stifte an der Justierstruktur des Magazins eine Feinjustierung des Magazins und damit der aus dem Magazin zu entnehmenden Mikrobauteile.

Vorzugsweise weist die Zentrierspitze eine Kegelstumpf- oder Kegelfläche auf. Der dazugehörige Kegelwinkel liegt vorteilhafterweise bei 50° bis 90°.

Ferner kann der Fangstift vorteilhafterweise auf einem Basisteil mit einer Auflageschulter angeordnet sein. Auf diese Auflageschulter legt sich das Folienmagazin während des Ausrichtvorgangs auf. Mittels einer auf der gegenüberliegenden Seite des Magazins angreifenden Klemmeinrichtung wird das Magazin auf diese Auflageschulter gedrückt und somit klemmend gehalten.

Vorzugsweise geht der Fangstift über einen kegelstumpfförmigen Bund in die Auflageschulter über. Während des Klemmvorgangs drückt sich der kegelstumpfförmige Bund in das Magazinmaterial, wodurch eine weitere Verbesserung der Klemmwirkung sowie eine verbesserte Positionstoleranz erzielt wird.

Die Länge des Fangstiftes ist vorzugsweise größer als die Magazindicke, so daß der Fangstift durch das Magazin hindurchgreift und auf der gegenüberliegenden Seite des Magazins herausragt. Die gegenüberliegende Ausrichtvorrichtung weist vorzugsweise eine Stiftaufnahme auf, in die der Fangstift eingreift. Dadurch kann gleichzeitig eine gegenseitige Feinjustierung von Ober- und Unterwerkzeug erfolgen, wodurch die Montagegenauigkeit weiter verbessert wird.

Vorzugsweise weist die Stiftaufnahme eine ebene Stirnfläche auf, die auf die Außenseite des Magazins drückt und somit im Zusammenwirken mit dem Fangstift bzw. dessen Auflageschulter das Magazin klemmend fixiert.

Unabhängig von der gegenseitigen Justierung von Ober- und Unterwerkzeug über die Fangstifte können Ober- und Unterwerkzeug bezüglich des jeweils anderen Werkzeugs justierbar angeordnet sein, was durch entsprechende Stelleinrichtungen ermöglicht wird.

Vorzugsweise ist der Stempel im Oberwerkzeug angeordnet, so daß die Mikrobauteile nach unten aus dem Magazin herausgedrückt werden können.

Die Montagevorrichtung hat den Vorteil, daß sich ein Materialschwund nicht nachteilig auf die Montage der Mikrobauteile auswirkt. Durch die Ausrichtung des Magazins anhand von Justierstrukturen, die im Magazin bereits bei der Herstellung der Mikrobauteile eingebracht werden, wird die im Magazin bereits realisierte Lagegenauigkeit der Mikrobauteile für die Montage genutzt. Durch die gleichzeitige klemmende Halterung des Magazins im Bereich der Justierstrukturen wird eine Durchbiegung des Magazins im Bereich der zu montierenden Mikrobauteile nahezu verhindert. Auf den Einsatz optischer Systeme für die Justierung kann verzichtet werden. Wenn optische Systeme eingesetzt werden, dann allenfalls noch zum Nachweis, ob ein Magazin in der Vorrichtung vorhanden ist oder nicht.

Die Justierung des Magazins und der Mikrobauteile kann mit einer zusätzlichen Justierung von Ober- und Unterwerkzeug der Montagevorrichtung kombiniert sein, wobei auch gleichzeitig eine Ausrichtung des Stempels bezüglich der bereits positionierten Mikrobauteile im gegenüberliegenden Werkzeug der Montagevorrichtung vorgenommen wird. Es erfolgt auf diese Art und Weise eine Justierung der Mikrobauteile bezüglich der Werkzeuge der Montagevorrichtung und der bereits vorhandenen Mikrobauteile, auf denen die zu montierenden Bauteile angebracht werden sollen. Eine Beschädigung der Mikrobauteile wird dadurch verhindert.

Vorzugsweise sind der oder die Stempel, die Montageplattform und die Stifte austauschbar. Dieser Austausch kann automatisch erfolgen, wodurch die Montagevorrichtung zum Montageroboter oder Stepper wird. Es wird dadurch eine Anpassung an verschiedene Mikrobauteile und Magazine möglich, so daß auch komplexe Strukturen auf einfache Weise zusammengebaut werden können.

Das Verfahren zum Montieren von in einem Magazin angeordneten Mikrobauteilen sieht vor, daß das Magazin erfaßt und mit dem zu montierenden Mikrobauteils positioniert und zunächst grob justiert wird. Anschließend wird das Magazin mittels im Magazin angeordneter Justierstrukturen auf Magazinebene und Clusterebene und/oder Mikrobauteilebene feinjustiert und anschließend wird das zu montierende Mikrobauteil aus dem Magazin herausgedrückt.

Die Feinjustierung erfolgt durch den Eingriff von mechanischen Ausrichtmitteln in die Justierstrukturen. Hierbei wird das Magazin in der Magazinebene verstellt oder verschoben.

Vorzugsweise wird das Magazin beim Justieren gleichzeitig oder zeitversetzt klemmend gehalten. Während des Justiervorgangs ist das Magazin in der horizontalen Ebene verschiebbar gelagert, um die durch Schwindung aufgetretene Positionsänderung ausgleichen zu können.

Das Magazin wird vorzugsweise oberhalb der Montageposition des Mikrobauteils angeordnet und auf eine Montageplattform herausgedrückt.

Das oder die sich auf der Montageplattform befindlichen Bauteile, wie z.B. Mikrobauteile oder größere Bauteilstrukturen, werden durch Anlegen eines Unterdrucks fixiert.

Das fertige Mikrosystem, z.B. ein Getriebe, wird beispielsweise durch einen Greifer entnommen.

Eine andere Alternative sieht vor, zum Entnehmen des fertigen Mikrosystems auch das Magazin einzusetzen. Vorzugsweise wird das letzte zu montierende Mikrobauteil nur teilweise aus dem Magazin herausgedrückt, so daß es einerseits noch im Magazin verankert ist und andererseits auch schon auf die zu bestückende Bauteilstruktur aufgedrückt ist und dieses hält. Mit dem Entfernen des Magazins aus der Montagevorrichtung kann dann auch das fertige Mikrosystem aus der Montagevorrichtung entnommen werden.

Beispielhafte Ausführungsformen der Erfindung werden nachfolgend anhand der Zeichnungen näher erläutert.

Es zeigen:
- Fig. 1: eine Draufsicht auf ein waferartiges Magazin,
- Fig. 2: eine Draufsicht auf einen Cluster des in Fig. 1 gezeigten Magazinwafers,
- Fig. 3: eine Prinzipskizze einer Montagevorrichtung,
- Fig. 4a,b: einen Vertikalschnitt durch eine Montagevorrichtung gemäß einer ersten Ausführungsform,
- Fig. 5: einen Vertikalschnitt durch eine Montagevorrichtung gemäß einer weiteren Ausführungsform, und
- Fig. 6: einen Detailschnitt einer Ausrichtvorrichtung gemäß einer weiteren Ausführungsform.

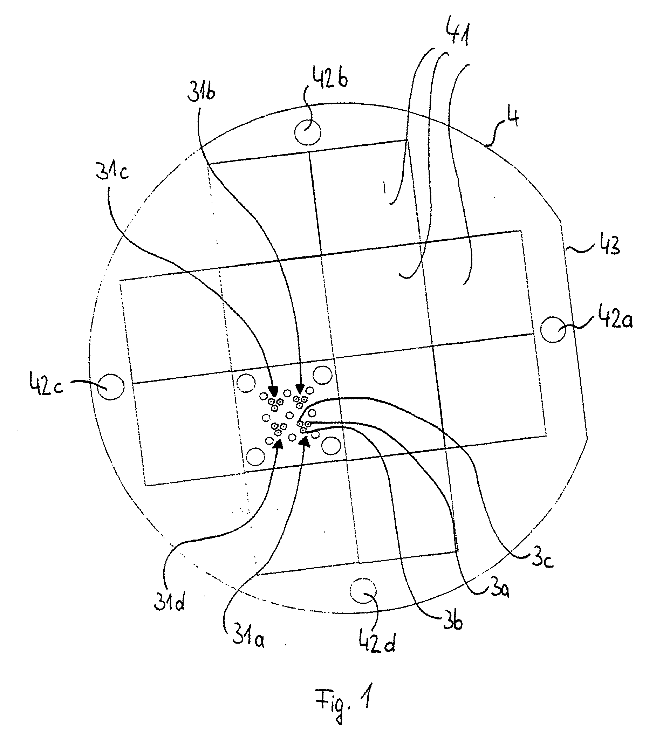

In der Fig. 1 ist die Draufsicht auf ein waferförmiges Magazin 4 dargestellt, das in quadratische Cluster 41 unterteilt ist, in denen die Mikrobauteile 3 angeordnet sind. Es handelt sich hierbei um ein sogenanntes Folienmagazin, in das die Mikrobauteile integriert sind. In der hier gezeigten Ausführungsform bestehen die Mikrobauteile 3 aus Zahnrädern, die als Planetenräder in ein Getriebe eingebaut werden sollen. Aus diesem Grund sind die Zahnräder entsprechend ihrer späteren Position im Getriebe in Dreiergruppen 31a-d angeordnet.

Das waferförmige Magazin 4 weist eine runde Außenkontur mit einer geraden Anschlagfläche 43 auf. Am Außenumfang sind äquidistant vier Justierstrukturen 42a-d in Form von kreisrunden Löchern vorgesehen. Es handelt sich hierbei um die Justierstrukturen auf Waferebene.

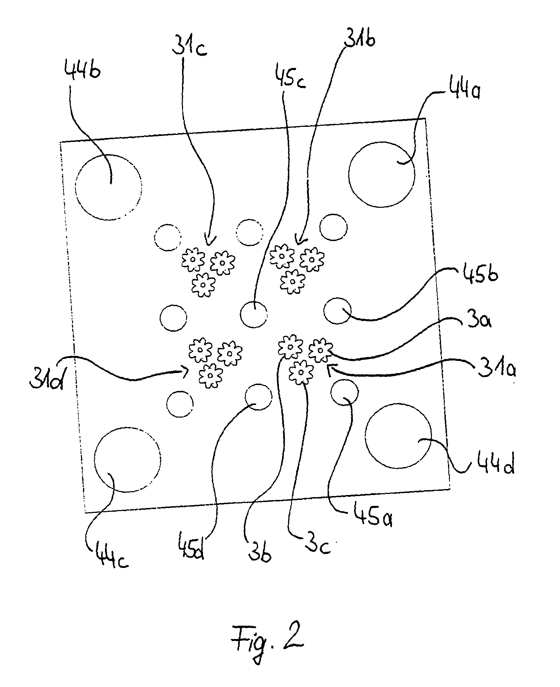

Jedes Cluster 41 besitzt in den vier Eckpunkten ebenfalls Justierstrukturen 44a-d, wie dies in der Fig. 2 im einzelnen zu sehen ist. Die vier Mikrobauteilgruppen besitzen ebenfalls zugeordnete Justierstrukturen 45a-d, die um die jeweilige Mikrobauteilgruppe 31a-d angeordnet sind. Es handelt sich sowohl bei den Justierstrukturen 44a-d als auch bei den Justierstrukturen 45a-d um Löcher, in die die Ausrichtmittel eingreifen können. Je nachdem, ob die Positionstoleranzen der Mikrobauteile aufgrund der Schwindung des Magazin- und Bauteilmaterials im Vergleich zu den Montagetoleranzen der Mikrobauteile groß oder klein sind, können die Justierstrukturen 42a-d, die Justierstrukturen 44a-d oder die Justierstrukturen 45a-d für die Ausrichtung des Magazins 4 bzw. der Mikrobauteile 3a-c genutzt werden.

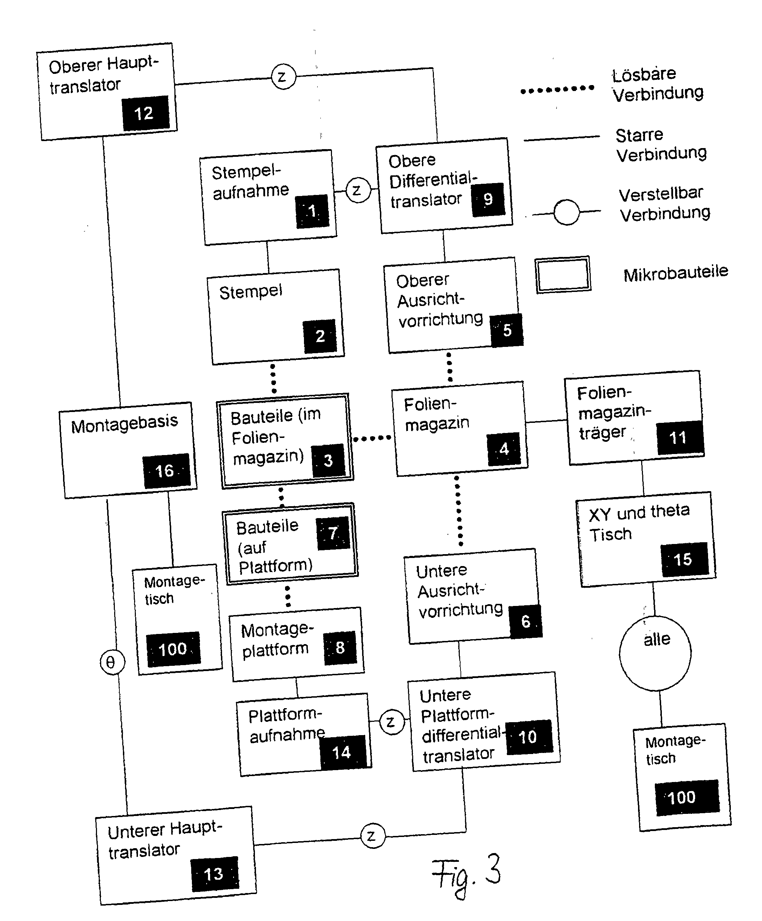

In der Fig. 3 ist eine Prinzipskizze einer erfindungsgemäßen Montagevorrichtung dargestellt. Das Folienmagazin 4 befindet sich auf einem Folienmagazinträger 11, der auf einem Tisch angeordnet ist, der sowohl eine Verschiebung in XY-Richtung als auch eine Schwenkbewegung um die Normale der Magazinoberfläche (Z-Achse) ermöglicht. Dieser sogenannte XYund Theta-Tisch 15 befindet sich auf einem Montagetisch 100. Das Oberwerkzeug umfaßt einen oberen Haupttranslator 12, der in Z-Richtung beweglich angeordnet ist. An oder in diesem Haupttranslator 12 ist ein oberer Differentialtranslator 9 angeordnet, der relativ zum oberen Haupttranslator 12 in Z-Richtung beweglich angeordnet ist. Der obere Differentialtranslator 9 trägt eine Stempelaufnahme 1, die bezüglich des oberen Differentialtranslators 9 ebenfalls in Z-Richtung beweglich angeordnet ist. Die Stempelaufnahme 1 trägt den Stempel 2, mit dem die Mikrobauteile 3, die im Folienmagazin angeordnet sind, aus dem Magazin herausgedrückt werden.

Das Unterwerkzeug weist ebenfalls einen unteren Haupttranslator 13 auf, der in Z-Richtung beweglich angeordnet ist. An oder in dem unteren Haupttranslator 13 ist ein unterer Differentialtranslator 10 ebenfalls in Z-Richtung beweglich angeordnet. Der untere Differentialtranslator 10 trägt eine Plattformaufnahme 14, auf der eine Montageplattform 8 befestigt ist, die gegebenenfalls bereits montierte Mikrobauteile 7 trägt. Sowohl der obere Haupttranslator 12 als auch der untere Haupttranslator 13 sind auf einer Montagebasis 16 angeordnet. Entweder der untere oder der obere Haupttranslator sind bezüglich der Montagebasis 16 um die Z-Achse schwenkbar angeordnet. Durch die vorgesehenen Verstellmöglichkeiten von Ober- und Unterwerkzeug bzw. deren Komponenten ist eine Justierung der Vorrichtungskomponenten zueinander möglich. Diese Justierung wird vorgenommen, bevor die Montage der Mikrobauteile erfolgt. Eine Veränderung der gegenseitigen Zuordnung der Komponenten ist dann nicht mehr erforderlich.

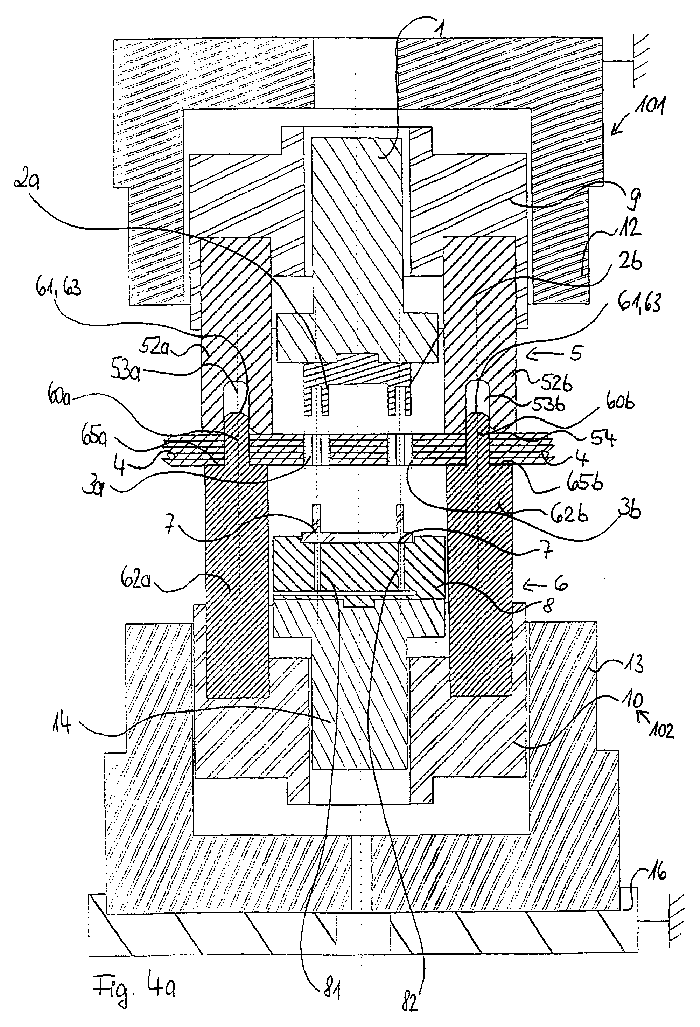

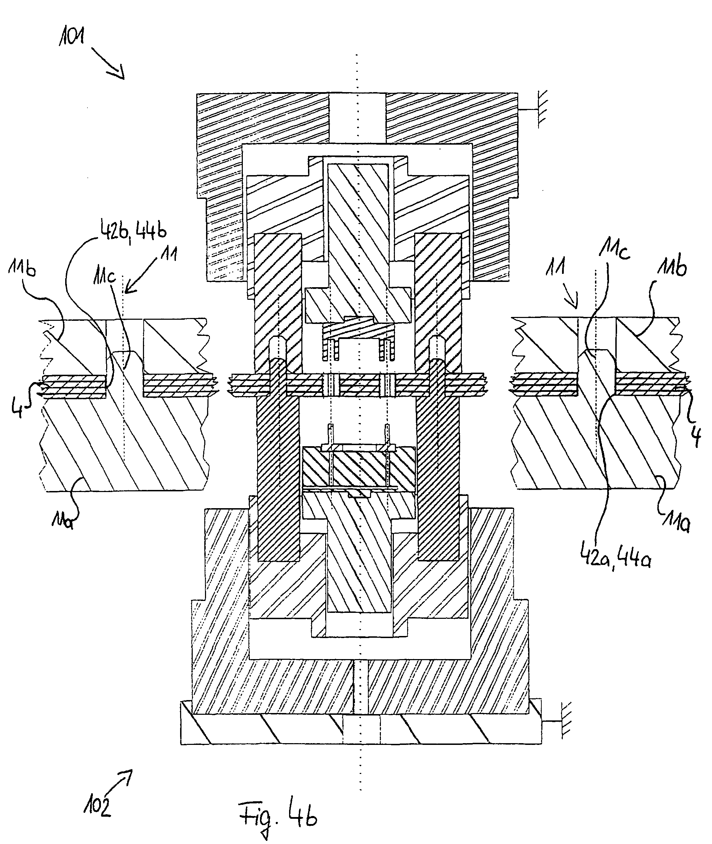

In den Fign. 4a,b ist ein Vertikalschnitt durch eine Montagevorrichtung dargestellt, die ein Oberwerkzeug 101 und ein Unterwerkzeug 102 aufweist, zwischen denen das Magazin 4 mit den Mikrobauteilen 3a und 3b horizontal angeordnet ist.

Das Magazin 4 wird von einem Magazinträger 11 gehalten und durch Verschieben des Magazinträgers 11 grob positioniert. Der Magazinträger 11 besteht aus einem Unterteil 11a und einem Oberteil 11b, wobei das Unterteil 11a Stifte 11c aufweist, die in die Justierstrukturen 42a-d bzw. 44a-d des Magazins 4 eingreifen. Die einzelnen Komponenten des Oberwerkzeugs 101 bzw. des Unterwerkzeugs 102 sind bereits im Zusammenhang mit der Fig. 3 beschrieben worden, so daß nachfolgend nur noch Details der Ausrichtvorrichtung erläutert werden sollen.

Die obere Ausrichtvorrichtung 5 ist im oberen Differentialtranslator 9 befestigt und wird durch die Vertikalbewegung des oberen Differentialtranslators angehoben oder abgesenkt. In der in Fig. 4a,b gezeigten Darstellung ist die obere Ausrichtvorrichtung 5 bereits auf der Oberseite des Folienmagazins 4 abgesenkt. Die obere Ausrichtvorrichtung 5 weist zwei Stifte 52a und 52b auf, zwischen denen die beiden Stempel 2a und 2b und die Stempelaufnahme 1 angeordnet sind. Die Stempelaufnahme 1 ist relativ zum oberen Differentialtranslator 9 in vertikaler Richtung beweglich angeordnet. Jeder Stift 52a und 52b weist am freien Ende eine axiale Bohrung auf, die als Stiftaufnahme 53a,b für die noch zu erläuternden Fangstifte 60a,b dienen. Ferner besitzen die Stifte 52a,b eine plane Stirnfläche 54, die als Klemmmittel auf die Oberseite des Magazins 4 drückt.

Gegenüber den Stiften 52a,b sind im Unterwerkzeug 102 zwei Fangstifte 60a und 60b der unteren Ausrichtvorrichtung 6 angeordnet. Diese Fangstifte 60a,b besitzen eine Zentrierspitze 61 mit einer kegelstumpfförmigen Fläche 63 und sind auf einem Basisteil 62a,b angeordnet, das über eine Auflageschulter 65a,b verfügt. Die Länge der Fangstifte 60a,b ist größer als die Dicke des Magazins 4, so daß die Fangstifte 60a,b durch die Justierstrukturen 45a,b hindurchgreifen und in die Stiftaufnahme 53a,b eingreifen. Es wird dadurch nicht nur eine Positionierung im Sinne einer Feinjustierung des Magazins 4 durchgeführt, sondern gegebenenfalls auch gleichzeitig eine gegenseitige Ausrichtung von Ober- und Unterwerkzeug. Das Magazin 4 wird zwischen der Stirnfläche 54 der Stifte 52a,b und der Auflageschulter 65a,b der Fangstifte 60a,b eingeklemmt.

Nachdem die Justierung und die Klemmung des Magazins 4 durchgeführt worden ist, wird die Stempelaufnahme 1 mit den Stempeln 2a,b abgesenkt und die Mikrobauteile 3a,3b nach unten aus dem Magazin 4 herausgedrückt. Auf der Plattformaufnahme 14 befindet sich die Montageplattform 8, die Ansaugkanäle 81 und 82 aufweist. Durch Anlegen eines Unterdrucks werden die Mikrobauteile 7a,b auf der Montageplattform 8 fixiert.

Durch die gegenseitige Ausrichtung von Ober- und Unterwerkzeug und die Justierung des Magazins 4 fluchten die Bohrungen der Zahnräder 3a,b mit den Zapfen der Mikrobauteile 7a,b. Durch das Absenken der Stempel 2a,b werden die Mikrobauteile 3a,b aus dem Magazin 4 nach unten herausgedrückt und auf die vorhandenen Mikrobauteile 7a,b aufgesetzt.

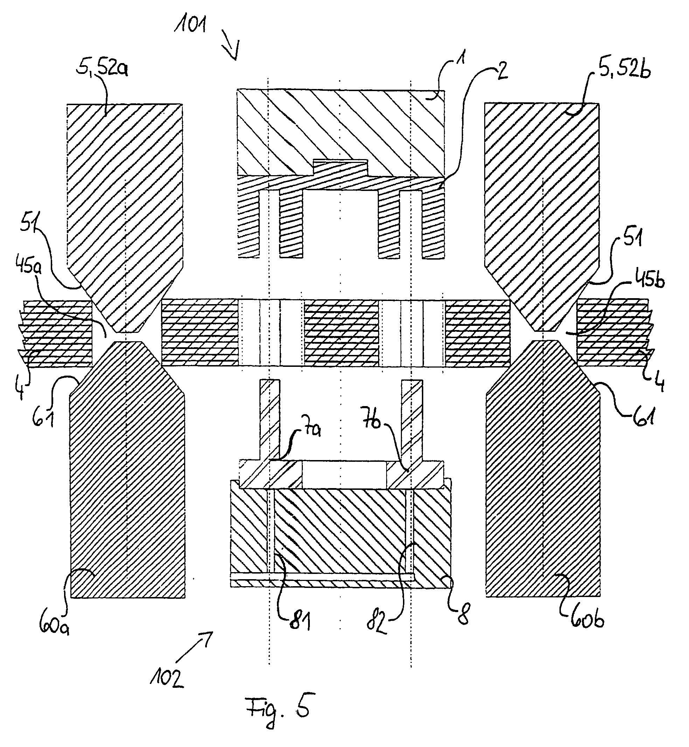

In der Fig. 5 ist eine weitere Ausführungsform dargestellt, die sich von der in der Fig. 4 gezeigten Ausführungsform durch eine geänderte Ausgestaltung der oberen und unteren Ausrichtungsvorrichtung unterscheidet. Sowohl die Stifte 52a,b als auch die Stifte 60a,b der Ausrichtvorrichtungen besitzen eine kegelstumpfförmige Zentrierspitze 61, die in die Bohrungen 45a,b eingreifen. Bei dieser Ausführungsform können die Stifte 52a,b und die Stifte 60a,b derart zusammenwirken, daß auch eine Ausrichtung von Ober- und Unterwerkzeug stattfindet. Der Durchmesser der Stifte 52a,b bzw. 60a,b ist größer als der Durchmesser der Justierstrukturen 45a,b des Magazins 4, so daß beim Eingreifen der Zentrierspitzen 51 und 61 eine Verschiebung und somit eine Justierung des Magazins 4 stattfindet.

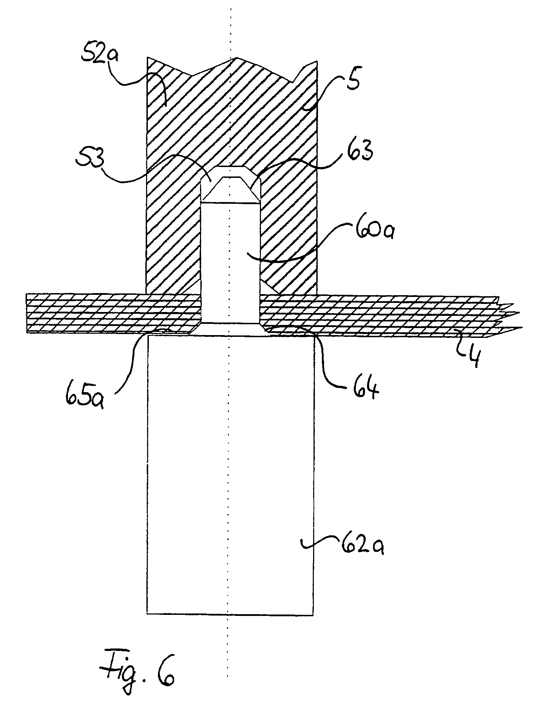

In der Fig. 6 ist eine weitere Ausführungsform eines Fangstiftes 60a dargestellt. Der Stift 52a besitzt eine Stiftaufnahme 53, in die der Fangstift 60a eingreift. Dieser besitzt einen kegelstumpfförmigen Bund 64, der in die Auflageschulter 65a übergeht und der sich während des Klemm- und Justiervorgangs in die Unterseite des Magazins 4 eindrückt. Dadurch wird eine verbesserte Klemmwirkung und eine präzisere Positionierung des Magazins erzielt.

### Bezugszeichen

- 1: Stempelaufnahme
- 2a,b: Stempel
- 3a-c: Mikrobauteile
- 4: Magazin
- 5: obere Ausrichtvorrichtung
- 6: untere Ausrichtvorrichtung
- 7a,b: Mikrobauteil
- 8: Montageplattform
- 9: oberer Differentialtranslator
- 10: unterer Differentialtranslator
- 11: Folienmagazinträger
- 11a: Unterteil des Magazinträgers
- 11b: Oberteil des Magazinträgers
- 11c: Stift
- 12: oberer Haupttranslator
- 13: unterer Haupttranslator
- 14: Plattformaufnahme
- 15: XY- und Theta-Tisch
- 16: Montagebasis
- 31a-d: Bauteilgruppe
- 41: Cluster
- 42a-d: Justierstruktur/Waferebene
- 43: Anschlagkante
- 44a-d: Justierstruktur/Clusterebene
- 45a-d: Justierstruktur/Gruppenebene
- 51: Zentrierspitze
- 52a,b: Stift
- 53a,b: Stiftaufnahme
- 54: Stirnfläche
- 60a,b: Fangstift
- 61: Zentrierspitze
- 62a,b: Basisteil
- 63: kegelstumpfförmige Fläche
- 64: Bund
- 65a,b: Auflageschulter
- 81: Ansaugkanal
- 82: Ansaugkanal
- 100: Montagetisch
- 101: Oberwerkzeug
- 102: Unterwerkzeug

## Patentansprüche

1. Montagevorrichtung für in einem Magazin angeordnete Mikrobauteile mit einem Oberwerkzeug (101) und einem Unterwerkzeug (102), die folgende Komponenten aufweisen:
- Mittel zur Grobjustierung des Magazins,
- Klemmmittel zum Fixieren des Magazins (4),
- mindestens einen Stempel (2a,b) zum Ausdrücken mindestens eines Mikrobauteils (3a,b) aus dem Magazin (4),
- eine Montageplattform (8) im Oberwerkzeug (101) oder im Unterwerkzeug (102) zur positionierten Aufnahme von Mikrobauteilen (3a,3b), **gekennzeichnet durch**
- mechanische Ausrichtmittel zur Feinjustierung, die in Justierstrukturen (42a-d,44a-d,45a-d) auf Magazinebene, und Clusterebene und/oder Mikrobauteilebene des Magazins (4) ein- oder angreifen und eine Ausrichtung der im Magazin befindlichen Mikrobauteile bewirken.

2. Montagevorrichtung nach Anspruch 1, **dadurch gekennzeichnet, daß** die Klemmmittel in die Ausrichtmittel integriert sind.

3. Montagevorrichtung nach Anspruch 1 oder 2, **dadurch gekennzeichnet, daß** die Ausrichtmittel eine obere und eine untere Ausrichtvorrichtung (5,6) umfassen, die gegenüberliegend angeordnet sind, wobei mindestens eine Ausrichtvorrichtung (5,6) in vertikaler Richtung beweglich angeordnet ist.

4. Montagevorrichtung nach Anspruch 3, **dadurch gekennzeichnet, daß** eine der Ausrichtvorrichtungen (5,6) mindestens einen Stift (52a,b,60a,b) aufweist.

5. Montagevorrichtung nach Anspruch 4, **dadurch gekennzeichnet, daß** der Stift ein Fangstift (60a,b) ist.

6. Montagevorrichtung nach Anspruch 5, **dadurch gekennzeichnet, daß** der Fangstift einen Durchmesser von 100 µm bis 3 mm aufweist.

7. Montagevorrichtung nach einem der Ansprüche 4 bis 6, **dadurch gekennzeichnet, daß** der Stift (52a,b) und/oder der Fangstift (60a,b) eine Zentrierspitze (51,61) aufweist.

8. Montagevorrichtung nach Anspruch 7, **dadurch gekennzeichnet, daß** die Zentrierspitze (51,61) eine Kegelstumpf- oder Kegelfläche (63) aufweist.

9. Montagevorrichtung nach Anspruch 7, **dadurch gekennzeichnet, daß** der Kegelwinkel der Kegelstumpf- oder Kegelfläche 50° bis 90° beträgt.

10. Montagevorrichtung nach einem der Ansprüche 5 bis 9, **dadurch gekennzeichnet, daß** der Fangstift (52a,b,60a,b) auf einem Basisteil (62a,b) mit einer Auflageschulter (65a,b) angeordnet ist.

11. Montagevorrichtung nach einem der Ansprüche 5 bis 10, **dadurch gekennzeichnet, daß** der Fangstift (52a,b,60a,b) über einen kegelstumpfförmigen Bund (64) in die Auflageschulter (65a,b) übergeht.

12. Montagevorrichtung nach einem der Ansprüche 5 bis 11, **dadurch gekennzeichnet, daß** die Länge des Fangstiftes (52a,b,60a,b) größer ist als die Dicke des Magazins (4).

13. Montagevorrichtung nach einem der Ansprüche 1 bis 12, **dadurch gekennzeichnet, daß** die obere und die untere Ausrichtvorrichtung (5,6) eine Stiftaufnahme (53a,b) zum Eingreifen des jeweils gegenüberliegenden Fangstiftes (60a,b) aufweist.

14. Montagevorrichtung nach Anspruch 13, **dadurch gekennzeichnet, daß** der die Stiftaufnahme (53a,b) aufweisende Stift (52a,b) eine ebene Stirnfläche (54) aufweist.

15. Montagevorrichtung nach einem der Ansprüche 1 bis 14, **dadurch gekennzeichnet, daß** das Ober- oder das Unterwerkzeug (101,102) bezüglich des jeweils anderen Werkzeugs justierbar angeordnet ist.

16. Montagevorrichtung nach einem der Ansprüche 1 bis 15, **dadurch gekennzeichnet, daß** der Stempel (2a,b) im Oberwerkzeug (101) angeordnet ist.

17. Montagevorrichtung nach einem der Ansprüche 1 bis 16, **dadurch gekennzeichnet, daß** Stempel (2a,b), Montageplattform (8) und Stifte (52a,b,60a,b) austauschbar sind.

18. Verfahren zum Montieren von in einem Magazin angeordneten Mikrobauteilen, bei dem
- das Magazin (4) erfaßt und mit dem zu montierenden Mikrobauteil (3a,3b) positioniert und grob justiert wird,
- das Magazin (4) mittels im Magazin angeordneter Justierstrukturen (42a-d,44a-d,45a-d) auf Magazinebene und Clusterebene und/oder Mikrobauteilebene feinjustiert wird, und anschließend das zu montierende Mikrobauteil (3a,3b) aus dem Magazin (4) herausgedrückt wird.

19. Verfahren nach Anspruch 18, **dadurch gekennzeichnet, daß** das Magazin (4) durch einen Eingriff von mechanischen Ausrichtmitteln in die Justierstrukturen (42a-d,44a-d,45a-d) feinjustiert wird.

20. Verfahren nach einem der Ansprüche 18 bis 19, **dadurch gekennzeichnet, daß** das Magazin (4) beim Justieren gleichzeitig oder zeitversetzt klemmend gehalten wird.

21. Verfahren nach einem der Ansprüche 18 bis 20, **dadurch gekennzeichnet, daß** das Magazin (4) zum Herausdrücken des Mikrobauteils (3a-3b) oberhalb der Montageposition des Mikrobauteils angeordnet wird.

22. Verfahren nach einem der Ansprüche 18 bis 21, **dadurch gekennzeichnet, daß** die Mikrobauteile (3a,3b) auf eine Montageplattform (8) herausgedrückt werden.

23. Verfahren nach Anspruch 22, **dadurch gekennzeichnet, daß** das oder die sich auf der Montageplattform (8) befindlichen Bauteile durch Anlegen eines Unterdrucks fixiert werden.

24. Scheibenförmiges Magazin, wobei das Magazinmaterial mindestens ein Mikrobauteil mindestens an seinen seitlichen Flächen formschlüssig umfaßt, **dadurch gekennzeichnet, daß** das Magazinmaterial Justierstrukturen (42a-d,44a-d,45a-d) zur Feinjustierung auf Magazinebene und Clusterebene- und/oder Mikrobauteilebene zum Ein- oder Angreifen von mechanischen Ausrichtmitteln bei der Montage der Mikrobauteile (3a,3b) aufweist, wobei die Justierstrukturen (42a-d,44a-d,45a-d) von der Magazinebene über die Clusterebene bis zur Mikrobauteilebene eine abnehmende Größe aufweisen.

25. Magazin nach Anspruch 24, **dadurch gekennzeichnet, daß** die Justierstrukturen (42a-d,44a-d45a-d) als kreisrunde, zylinder-, dreikant-, vierkant- oder polygonförmige Strukturen im Magazin (4) ausgebildet sind.

26. Magazin nach Anspruch 24 oder 25, **dadurch gekennzeichnet, daß** die Justierstrukturen (42a-d,44a-d,45a-d) Öffnungen mit einem Durchmesser im Bereich von 100 µm bis 3 mm sind.

27. Magazin nach einem der Ansprüche 24 bis 26, **dadurch gekennzeichnet, daß** die Justierstrukturen (42a-d,44a-d,45a-d) auf der Magazinebene einen Durchmesser im Bereich von 1 mm bis 3 mm aufweisen.

28. Magazin nach einem der Ansprüche 24 bis 27, **dadurch gekennzeichnet, daß** die Justierstrukturen (42a-d,44a-d,45a-d) auf der Clusterebene einen Durchmesser von 500 µm bis 1 mm aufweisen.

29. Magazin nach einem der Ansprüche 24 bis 28, **dadurch gekennzeichnet, daß** die Justierstrukturen (42a-d,44a-d,45a-d) auf der Mikrobauteilebene einen Durchmesser von 100 µm bis 500 µm aufweisen.

## Claims

1. Assembly device for microcomponents that are arranged in a magazine, comprising an upper tool (101) and a lower tool (102), which have the following components:
- means for rough adjustment of the magazine,
- clamping means for fixing the magazine (4),
- at least one plunger (2a,b) for ejecting at least one microcomponent (3a,b) from the magazine (4),
- an assembly platform (8) in the upper tool (101) or in the lower tool (102) for receiving microcomponents (3a, 3b) in a positioned manner, **characterized by**
- mechanical alignment means for fine adjustment, which engage in or act on adjustment structures (42a-d, 44a-d, 45a-d) on the magazine level and the cluster level and/or the microcomponent level of the magazine (4) and bring about an alignment of the microcomponents located in the magazine.

2. Assembly device according to Claim 1, **characterized in that** the clamping means are integrated into the alignment means.

3. Assembly device according to Claim 1 or 2, **characterized in that** the alignment means comprise an upper and a lower alignment device (5, 6) which are arranged opposite one another, at least one alignment device (5, 6) being arranged so as to be movable in the vertical direction.

4. Assembly device according to Claim 3, **characterized in that** one of the alignment devices (5, 6) has at least one pin (52a,b, 60a,b).

5. Assembly device according to Claim 4, **characterized in that** the pin is a pilot pin (60a,b).

6. Assembly device according to Claim 5, **characterized in that** the pilot pin has a diameter of 100 µm to 3 mm.

7. Assembly device according to one of Claims 4 to 6, **characterized in that** the pin (52a,b) and/or the pilot pin (60a,b) has a center point (51, 61).

8. Assembly device according to Claim 7, **characterized in that** the center point (51, 61) has a frustoconical or conical surface (63).

9. Assembly device according to Claim 7, **characterized in that** the cone angle of the frustoconical or conical surface is 50° to 90°.

10. Assembly device according to one of Claims 5 to 9, **characterized in that** the pilot pin (52a,b, 60a,b) is arranged on a base part (62a,b) with a supporting shoulder (65a,b).

11. Assembly device according to one of Claims 5 to 10, **characterized in that** the pilot pin (52a,b, 60a,b) merges into the supporting shoulder (65a,b) via a frustoconical collar (64).

12. Assembly device according to one of Claims 5 to 11, **characterized in that** the length of the pilot pin (52a,b, 60a,b) is greater than the thickness of the magazine (4).

13. Assembly device according to one of Claims 1 to 12, **characterized in that** the upper and the lower alignment device (5, 6) have a pin socket (53a,b) for engagement with the respectively opposite pilot pin (60a,b).

14. Assembly device according to Claim 13, **characterized in that** the pin (52a,b) having the pin socket (53a,b) has a planar end face (54).

15. Assembly device according to one of Claims 1 to 14, **characterized in that** the upper or the lower tool (101,102) is arranged so as to be adjustable relative to the respectively other tool.

16. Assembly device according to one of Claims 1 to 15, **characterized in that** the plunger (2a,b) is arranged in the upper tool (101).

17. Assembly device according to one of Claims 1 to 16, **characterized in that** the plunger (2a,b), the assembly platform (8) and the pins (52a,b, 60a,b) are exchangeable.

18. Method for assembling microcomponents that are arranged in a magazine, in which
- the magazine (4) is grasped and is positioned and roughly adjusted together with the microcomponent (3a, 3b) to be assembled,
- the magazine (4) is finely adjusted by means of adjustment structures (42a-d, 44a-d, 45a-d) that are arranged in the magazine on the magazine level and the cluster level and/or the microcomponent level, and
- the microcomponent (3a, 3b) that is to be assembled is subsequently ejected from the magazine (4).

19. Method according to Claim 18, **characterized in that** the magazine (4) is finely adjusted by an engagement of mechanical alignment means in the adjustment structures (42a-d, 44a-d, 45a-d).

20. Method according to one of Claims 18 to 19, **characterized in that** the magazine (4) is kept damped at the same time or offset in time during adjustment.

21. Method according to one of Claims 18 to 20, **characterized in that**, to eject the microcomponent (3a-3b), the magazine (4) is arranged above the assembly position of the microcomponent.

22. Method according to one of Claims 18 to 21, **characterized in that** the microcomponents (3a, 3b) are ejected onto an assembly platform (8).

23. Method according to Claim 22, **characterized in that** the component or components that are located on the assembly platform (8) are fixed by applying a vacuum.

24. Disc-shaped magazine, the magazine material holding at least one microcomponent at least along its lateral surfaces with a positive fit, **characterized in that** the magazine material has adjustment structures (42a-d, 44a-d, 45a-d) for fine adjustment on the magazine level and the cluster level and/or the microcomponent level for the engaging or acting of mechanical alignment means during assembly of the microcomponents (3a, 3b), the adjustment structures (42a-d, 44a-d, 45a-d) having a decreasing size from the magazine level to the cluster level to the microcomponent level.

25. Magazine according to Claim 24, **characterized in that** the adjustment structures (42a-d, 44a-d, 45a-d) are configured as circular, cylindrical, triangular, square or polygonal structures in the magazine (4).

26. Magazine according to Claim 24 or 25, **characterized in that** the adjustment structures (42a-d, 44a-d, 45a-d) are openings with a diameter ranging from 100 µm to 3 mm.

27. Magazine according to one of Claims 24 to 26, **characterized in that** the adjustment structures (42a-d, 44a-d, 45a-d) on the magazine level have a diameter in the range from 1 mm to 3 mm.

28. Magazine according to one of Claims 24 to 27, **characterized in that** the adjustment structures (42a-d, 44a-d, 45a-d) on the cluster level have a diameter of 500 µm to 1 mm.

29. Magazine according to one of Claims 24 to 28, **characterized in that** the adjustment structures (42a-d, 44a-d, 45a-d) on the microcomponent level have a diameter of 100 µm to 500 µm.

## Revendications

1. Dispositif de montage pour microcomposants disposés dans un magasin, comprenant un outil supérieur (101) et un outil inférieur (102), qui présentent les composants suivants:
- des moyens pour l'ajustage grossier du magasin,
- des moyens de serrage pour la fixation du magasin (4),
- au moins un poinçon (2a,b) pour presser au moins un microcomposant (3a,b) hors du magasin (4),
- une plate-forme de montage (8) dans l'outil supérieur (101) ou dans l'outil inférieur (102) pour la réception en position de microcomposants (3a, 3b), **caractérisé par**
- des moyens d'orientation mécaniques pour l'ajustement fin, qui viennent en prise dans ou sur des structures d'ajustement (42a-d, 44a-d, 45a-d) au niveau du magasin et au niveau du groupe et/ou au niveau du microcomposant du magasin (4) et provoquent une orientation des microcomposants se trouvant dans le magasin.

2. Dispositif de montage selon la revendication 1, **caractérisé en ce que** les moyens de serrage sont intégrés dans les moyens d'orientation.

3. Dispositif de montage selon la revendication 1 ou 2, **caractérisé en ce que** les moyens d'orientation comprennent un dispositif d'orientation supérieur et inférieur (5, 6), lesquels sont disposés en regard, au moins un dispositif d'orientation (5, 6) étant disposé de manière mobile dans la direction verticale.

4. Dispositif de montage selon la revendication 3, **caractérisé en ce que** l'un des dispositifs d'orientation (5, 6) présente au moins une goupille (52a,b, 60a,b).

5. Dispositif de montage selon la revendication 4, **caractérisé en ce que** la goupille est un pilote conique (60a,b).

6. Dispositif de montage selon la revendication 5, **caractérisé en ce que** le pilote conique présente un diamètre de 100 µm à 3 mm.

7. Dispositif de montage selon l'une quelconque des revendications 4 à 6, **caractérisé en ce que** la goupille (52a,b) et/ou le pilote conique (60a,b) présente une pointe de centrage (51, 61).

8. Dispositif de montage selon la revendication 7, **caractérisé en ce que** la pointe de centrage (51, 61) présente une surface tronconique ou conique (63).

9. Dispositif de montage selon la revendication 7, **caractérisé en ce que** l'angle de conicité de la surface tronconique ou conique est compris entre 50° et 90°.

10. Dispositif de montage selon l'une quelconque des revendications 5 à 9, **caractérisé en ce que** le pilote conique (52a,b, 60a,b) est disposé sur une partie de base (62a,b) avec un épaulement d'appui (65a,b).

11. Dispositif de montage selon l'une quelconque des revendications 5 à 10, **caractérisé en ce que** le pilote conique (52a,b, 60a,b) se prolonge par le biais d'un épaulement de forme tronconique (64) dans l'épaulement d'appui (65a,b).

12. Dispositif de montage selon l'une quelconque des revendications 5 à 11, **caractérisé en ce que** la longueur du pilote conique (52a,b, 60a,b) est plus grande que l'épaisseur du magasin (4).

13. Dispositif de montage selon l'une quelconque des revendications 1 à 12, **caractérisé en ce que** le dispositif d'orientation supérieur et le dispositif d'orientation inférieur (5, 6) présentent un logement de goupille (53a,b) pour engager le pilote conique respectivement opposé (60a,b).

14. Dispositif de montage selon la revendication 13, **caractérisé en ce que** la goupille (52a,b) présentant le logement de goupille (53a,b) présente une face frontale plane (54).

15. Dispositif de montage selon l'une quelconque des revendications 1 à 14, **caractérisé en ce que** l'outil supérieur ou l'outil inférieur (101, 102) est disposé de manière ajustable par rapport à l'autre outil respectif.

16. Dispositif de montage selon l'une quelconque des revendications 1 à 15, **caractérisé en ce que** le poinçon (2a,b) est disposé dans l'outil supérieur (101).

17. Dispositif de montage selon l'une quelconque des revendications 1 à 16, **caractérisé en ce que** le poinçon (2a,b), la plate-forme de montage (8) et les goupilles (52a,b, 60a,b) sont remplaçables.

18. Procédé de montage de microcomposants disposés dans un magasin, dans lequel:
- le magasin (4) est saisi et est positionné avec le microcomposant (3a, 3b) à monter et est grossièrement ajusté,
- le magasin (4) est finement ajusté au moyen de structures d'ajustement (42a-d, 44a-d, 45a-d) disposées dans le magasin au niveau du magasin et au niveau du groupe et/ou au niveau du microcomposant, et
- ensuite le microcomposant (3a, 3b) à monter est pressé hors du magasin (4).

19. Procédé selon la revendication 18, **caractérisé en ce que** le magasin (4) est finement ajusté par un engagement de moyens d'orientation mécaniques dans les structures d'ajustement (42ad, 44a-d, 45a-d).

20. Procédé selon l'une quelconque des revendications 18 à 19, **caractérisé en ce que** le magasin (4) lors de l'ajustement est maintenu par serrage simultanément ou de manière retardée dans le temps.

21. Procédé selon l'une quelconque des revendications 18 à 20, **caractérisé en ce que** le magasin (4) est disposé au-dessus de la position de montage du microcomposant en vue de l'extraction par pressage du microcomposant (3a-3b).

22. Procédé selon l'une quelconque des revendications 18 à 21, **caractérisé en ce que** les microcomposants (3a, 3b) sont extraits par pressage sur une plate-forme de montage (8).

23. Procédé selon la revendication 22, **caractérisé en ce que** le ou les composants se trouvant sur la plate-forme de montage (8) sont fixés par l'application d'une pression négative.

24. Magasin en forme de disque, dans lequel le matériau du magasin entoure au moins un microcomposant au moins au niveau de ses faces latérales par engagement positif, **caractérisé en ce que** le matériau du magasin présente des structures d'ajustement (42a-d, 44a-d, 45a-d) pour l'ajustement fin au niveau du magasin et au niveau du groupe et/ou au niveau du microcomposant, destinée à être engagées par des moyens d'orientation mécaniques lors du montage des microcomposants (3a, 3b), les structures d'ajustement (42a-d, 44a-d, 45a-d) présentant une taille diminuant depuis le niveau du magasin, en passant par le niveau du groupe, jusqu'au niveau du microcomposant.

25. Magasin selon la revendication 24, **caractérisé en ce que** les structures d'ajustement (42a-d, 44a-d, 45a-d) sont réalisées sous forme de structures circulaires, cylindriques, triangulaires, quadrangulaires ou polygonales dans le magasin (4).

26. Magasin selon la revendication 24 ou 25, **caractérisé en ce que** les structures d'ajustement (42a-d, 44a-d, 45a-d) sont des ouvertures ayant un diamètre dans la plage de 100 µm à 3 mm.

27. Magasin selon l'une quelconque des revendications 24 à 26, **caractérisé en ce que** les structures d'ajustement (42a-d, 44a-d, 45a-d) au niveau du magasin présentent un diamètre dans la plage de 1 mm à 3 mm.

28. Magasin selon l'une quelconque des revendications 24 à 27, **caractérisé en ce que** les structures d'ajustement (42a-d, 44a-d, 45a-d) au niveau du groupe présentent un diamètre de 500 µm à 1 mm.

29. Magasin selon l'une quelconque des revendications 24 à 28, **caractérisé en ce que** les structures d'ajustement (42a-d, 44a-d, 45a-d) au niveau du microcomposant présentent un diamètre de 100 µm à 500 µm.
